# EUROPEAN PATENT APPLICATION

(11) **EP 4 235 095 A1**
(43) Date of publication of application: **30.08.2023**
(21) Application number: 21882522.2
(22) Date of filing: 29.09.2021
(51) Int. Cl.: G01C 3/06, G01S 7/481, H01S 5/0239, H01S 5/40

(54) **LIGHT EMITTING DEVICE AND RANGING SYSTEM**

(30) Priority: 21.10.2020 JP 2020176730
(71) Applicant: Sony Semiconductor Solutions Corporation, Atsugi-shi, Kanagawa 243-0014 (JP)
(72) Inventor: IMAYOSHI Kohei, Kikuchi-gun, Kumamoto 869-1102 (JP); TATEBAYASHI Katsuaki, Kikuchi-gun, Kumamoto 869-1102 (JP); KUNIMITSU Takayuki, Kikuchi-gun, Kumamoto 869-1102 (JP); KIMURA Katsuji, Atsugi-shi, Kanagawa 243-0014 (JP); YAMANAKA Hiroyuki, Kikuchi-gun, Kumamoto 869-1102 (JP); RYU Heiichiro, Kikuchi-gun, Kumamoto 869-1102 (JP); KAWABATA Jun, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2021/035802
(87) International publication number: WO 2022/085381

(57) **Abstract**

Provided are a light emitting device and a ranging system capable of moving an irradiation position of light by a suitable method.

The light emitting device according to the present disclosure includes a plurality of light emitting elements configured to generate light, and a moving unit configured to move an irradiation position of the light by driving a predetermined portion related to the light in a first direction, in which the light emitting elements are arranged at intersections of a plurality of first straight lines extending in a second direction orthogonal to the first direction and a plurality of second straight lines extending in a third direction parallel to neither the first direction nor the second direction, the first straight lines include a straight line A and a straight line B adjacent to the straight line A in the first direction, and the light emitting elements on the straight line A and the light emitting elements on the straight line B are arranged so as not to be adjacent to each other in the first direction. This makes it possible to move the irradiation position of the light by a suitable method, for example, to move the irradiation position of the light to various places by uniaxial drive.

## Description

### TECHNICAL FIELD

The present disclosure relates to a light emitting device and a ranging system.

### BACKGROUND ART

A ranging system that measures a distance to a subject by irradiating a plurality of ranging points with light from a plurality of light emitting elements of a light emitting device is known. In this case, in order to irradiate a large number of ranging points with light using a small number of light emitting elements, it is conceivable to move an irradiation position of the light by driving a predetermined portion of the light emitting device. For example, it is conceivable to move the irradiation position of the light to various places by driving an optical system of the light emitting device in an X-axis direction and a Y-axis direction.

### CITATION LIST

### PATENT DOCUMENT

Patent Document 1: WO 2020/030916 A
Patent Document 2: Japanese Patent Application Laid-Open (Translation of PCT Application) No. 2017-508955
Patent Document 3: Japanese Patent Application Laid-Open (Translation of PCT Application) No. 2018-529124
Patent Document 4: US 2019/0187255 A

### SUMMARY OF THE INVENTION

### PROBLEMS TO BE SOLVED BY THE INVENTION

Driving the above-described predetermined portion of the light emitting device in a complicated manner in order to move the irradiation position of the light to various places, however, raises a possibility of interfering with the implementation of a suitable light emitting device, such as a reduction in size, an increase in performance, or a reduction in cost of the light emitting device.

The present disclosure therefore provides a light emitting device and a ranging system capable of moving an irradiation position of light by a suitable method.

### SOLUTIONS TO PROBLEMS

A light emitting device according to a first aspect of the present disclosure includes: a plurality of light emitting elements configured to generate light; and a moving unit configured to move an irradiation position of the light by driving a predetermined portion related to the light in a first direction, in which the light emitting elements are arranged at intersections of a plurality of first straight lines extending in a second direction orthogonal to the first direction and a plurality of second straight lines extending in a third direction parallel to neither the first direction nor the second direction, the first straight lines include a straight line A and a straight line B adjacent to the straight line A in the first direction, and the light emitting elements on the straight line A and the light emitting elements on the straight line B are arranged so as not to be adjacent to each other in the first direction. This makes it possible to move the irradiation position of the light by a suitable method, for example, to move the irradiation position of the light to various places by uniaxial drive.

Furthermore, according to the first aspect, the predetermined portion may include an optical system through which the light from the light emitting elements passes. This makes it possible to move the irradiation position of the light by driving the optical system rather than the light emitting elements, for example.

Furthermore, according to the first aspect, the optical system may include at least one of a lens or a diffractive optical element through which the light from the light emitting elements passes. This makes it possible to move the irradiation position of the light by driving the lens or the diffractive optical element rather than the light emitting elements, for example.

Furthermore, according to the first aspect, the moving unit may include a coil, a magnet, a piezoelectric element, or a shape-memory alloy. This makes it possible to move the irradiation position of the light by the action of the coil, the magnet, the piezoelectric element, or the shape-memory alloy, for example.

Furthermore, according to the first aspect, the moving unit may be provided only in the first direction of the predetermined portion out of the first direction and the second direction of the predetermined portion. This allows a reduction in size of the light emitting device in the second direction, for example.

Furthermore, according to the first aspect, the moving unit may drive the predetermined portion in the first direction and a direction opposite to the first direction. This makes it possible to move the irradiation position of the light backward and forward, for example.

Furthermore, the light emitting device according to the first aspect may further include a substrate on which the light emitting elements are provided. This makes it possible to provide an array of the light emitting elements on the substrate, for example.

Furthermore, according to the first aspect, the light emitting elements may be provided on a first surface of the substrate, and the light from the light emitting elements may pass through the substrate from the first surface to a second surface to exit from the second surface of the substrate. This makes it possible to implement a back-illuminated light emitting device, for example.

Furthermore, according to the first aspect, the light emitting elements may be arranged in a triangular lattice. This makes it possible to make density of the light emitting elements on the substrate uniform, for example.

Furthermore, according to the first aspect, in a case where a minimum pitch between the light emitting elements in the second direction is Δ, a minimum pitch between the light emitting elements in the first direction may be N * Δ (where N is an integer greater than or equal to 2). This makes it possible to arrange the light emitting elements so as to be suitable for uniaxial drive in the first direction, for example.

Furthermore, according to the first aspect, in a case where a minimum pitch between the light emitting elements in the second direction is Δ, a pitch in the first direction between the light emitting elements adjacent to each other in the first direction may be N² * Δ (where N is an integer greater than or equal to 2). This makes it possible to arrange the light emitting elements so as to be suitable for uniaxial drive in the first direction, for example.

Furthermore, according to the first aspect, in a case where a minimum pitch between the light emitting elements in the second direction is Δ, a pitch in the second direction between the light emitting elements adjacent to each other in the second direction may be N * Δ (where N is an integer greater than or equal to 2). This makes it possible to arrange the light emitting elements so as to be suitable for uniaxial drive in the first direction, for example.

Furthermore, according to the first aspect, in a case where a minimum pitch between the light emitting elements in the second direction is Δ, a region provided for each of the light emitting elements may be square with a side length of N * Δ (where N is an integer greater than or equal to 2). This allows a reduction in density of the light emitting elements on the substrate as compared with a case where the region provided for each light emitting element is square with a side length of Δ, for example.

A ranging system according to a second aspect of the present disclosure includes a light emitting device configured to irradiate a subject with light; a light receiving device configured to receive light reflected off the subject; and a ranging device configured to measure a distance to the subject on the basis of the light received by the light receiving device, in which the light emitting device includes: a plurality of light emitting elements configured to generate the light; and a moving unit configured to move an irradiation position of the light by driving a predetermined portion related to the light in a first direction, the light emitting elements are arranged at intersections of a plurality of first straight lines extending in a second direction orthogonal to the first direction and a plurality of second straight lines extending in a third direction parallel to neither the first direction nor the second direction, the first straight lines include a straight line A and a straight line B adjacent to the straight line A in the first direction, and the light emitting elements on the straight line A and the light emitting elements on the straight line B are arranged so as not to be adjacent to each other in the first direction. This makes it possible to move the irradiation position of the light by a suitable method, for example, to move the irradiation position of the light to various places by uniaxial drive.

Furthermore, according to the second aspect, the light receiving device may include an imaging unit configured to capture an image of the light reflected off the subject. This makes it possible to perform distance measurement using an image, for example.

Furthermore, according to the second aspect, the light receiving device may be provided in the second direction of the light emitting device. This makes it possible to prevent, when the above-described predetermined portion is driven in the first direction, the light receiving device from interfering with the driving of the predetermined portion, for example.

Furthermore, according to the second aspect, at least a part of the light emitting device and at least a part of the light receiving device may be provided on a surface of the same substrate. This makes it possible to provide, with the substrate reduced in size, at least the part of the light emitting device and at least the part of the light receiving device on the surface of the substrate, for example.

Furthermore, according to the second aspect, in a case where a minimum pitch between the light emitting elements in the second direction is Δ, a pitch in the first direction between the light emitting elements adjacent to each other in the first direction may be N² * Δ (where N is an integer greater than or equal to 2). This makes it possible to arrange the light emitting elements so as to be suitable for uniaxial drive in the first direction, for example.

Furthermore, according to the second aspect, the moving unit may perform an operation of driving the predetermined portion in the first direction N² - 1 times to cause a plurality of ranging points to be sequentially irradiated with the light. This makes it possible to move the irradiation position of the light to various places by repeating the operation, for example.

Furthermore, according to the second aspect, the moving unit may perform an operation of driving the predetermined portion in the first direction and an operation of driving the predetermined portion in a direction opposite to the first direction N² - 1 times to cause a plurality of ranging points to be sequentially irradiated with the light. This makes it possible to move the irradiation position of the light to various places by repeating the operations, for example.

A light emitting device according to a third aspect of the present disclosure includes a plurality of light emitting elements configured to generate light; and a moving unit configured to move an irradiation position of the light by driving a predetermined portion related to the light in a first direction, in which, in a case where a minimum pitch between the light emitting elements in a second direction orthogonal to the first direction is Δ, a pitch in the first direction between the light emitting elements adjacent to each other in the first direction is N² * Δ (where N is an integer greater than or equal to 2), and a pitch in the second direction between the light emitting elements adjacent to each other in the second direction is N * Δ. This makes it possible to move the irradiation position of the light by a suitable method, for example, to move the irradiation position of the light to various places by uniaxial drive.

### BRIEF DESCRIPTION OF DRAWINGS

Fig. 1 is a block diagram illustrating a configuration of a ranging system according to a first embodiment.
Fig. 2 is a cross-sectional view of structures of a light emitting device and a light receiving device according to the first embodiment.
Fig. 3 is a cross-sectional view of a structure of the light emitting device according to the first embodiment.
Fig. 4 is another cross-sectional view of the structure of the light emitting device according to the first embodiment.
Fig. 5 is a plan view of an arrangement example of light emitting elements according to the first embodiment.
Fig. 6 is a plan view of another arrangement example of the light emitting elements according to the first embodiment.
Fig. 7 is a plan view of another arrangement example of the light emitting elements according to the first embodiment.
Fig. 8 is a plan view for describing an operation example of the light emitting elements illustrated in Fig. 5.
Fig. 9 is a plan view for describing an operation example of the light emitting elements illustrated in Fig. 6.
Fig. 10 is a plan view for describing an operation example of the light emitting elements illustrated in Fig. 7.
Fig. 11 is a plan view (1/4) for describing details of the operation example of the light emitting elements illustrated in Fig. 5.
Fig. 12 is a plan view (2/4) for describing the details of the operation example of the light emitting elements illustrated in Fig. 5.
Fig. 13 is a plan view (3/4) for describing the details of the operation example of the light emitting elements illustrated in Fig. 5.
Fig. 14 is a plan view (4/4) for describing the details of the operation example of the light emitting elements illustrated in Fig. 5.
Fig. 15 is a plan view (1/2) for describing another operation example of the light emitting elements illustrated in Fig. 5.
Fig. 16 is a plan view (2/2) for describing another operation example of the light emitting elements illustrated in Fig. 5.
Fig. 17 is a perspective view for describing details of the light emitting device according to the first embodiment.
Fig. 18 is another perspective view for describing the details of the light emitting devices according to the first embodiment.

### MODE FOR CARRYING OUT THE INVENTION

Hereinafter, an embodiment of the present disclosure will be described with reference to the drawings.

### (First embodiment)

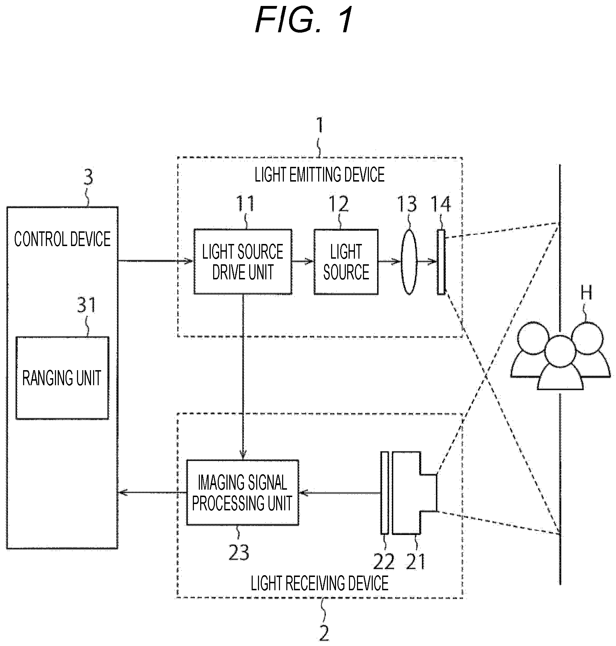

Fig. 1 is a block diagram illustrating a configuration of a ranging system according to a first embodiment. The ranging system illustrated in Fig. 1 includes a light emitting device 1, a light receiving device 2, and a control device 3.

The light emitting device 1 includes a plurality of light emitting elements (to be described later) that generates light, and a subject H is irradiated with the light from the light emitting elements. The subject H is three persons in Fig. 1, but may be a different subject. The light receiving device 2 receives light reflected off the subject H. The control device 3 controls various operations of the ranging system illustrated in Fig. 1, and measures a distance to the subject H on the basis of, for example, the light received by the light receiving device 2. The control device 3 is an example of a ranging device according to the present disclosure.

The light emitting device 1 includes a light source drive unit 11, a light source 12, a collimating lens 13, and a diffractive optical element (DOE) 14. The collimating lens 13 and the diffractive optical element 14 are examples of an optical system according to the present disclosure. The light receiving device 2 includes a lens unit 21, an imaging unit 22, and an imaging signal processing unit 23. The control device 3 includes a ranging unit 31.

The light source drive unit 11 drives the light source 12 to cause the light source 12 to generate light. The light source 12 includes the above-described plurality of light emitting elements. The light source drive unit 11 according to the present embodiment drives such light emitting elements to cause the light emitting elements to generate light. Each light emitting element according to the present embodiment has, for example, a vertical cavity surface emitting laser (VCSEL) structure, and generates laser light. The light generated from the light source 12 is, for example, visible light or infrared light.

The collimating lens 13 collimates the light from the light source 12. As a result, the light from the light source 12 becomes parallel light and is emitted toward the diffractive optical element 14. The diffractive optical element 14 diffracts the parallel light from the collimating lens 13. As a result, the parallel light from the collimating lens 13 becomes light (irradiation light) with which the subject H is irradiated and is emitted from the light emitting device 1. The light emitting device 1 irradiates the subject H with the irradiation light. The light with which the subject H is irradiated is reflected off the subject H and received by the light receiving device 2.

The lens unit 21 includes a plurality of lenses (to be described later), and causes such lenses to collect and condense light reflected off the subject H. Each of the lenses is covered with an antireflection film for preventing reflection of light. The antireflection film may serve as a band pass filter (BPF) that transmits light identical in wavelength to the light emitted from the light emitting device 1.

The imaging unit 22 captures an image of the light collected and condensed by the lens unit 21 and outputs an imaging signal obtained by the image capture. The imaging unit 22 is, for example, a solid-state imaging device such as a charge coupled device (CCD) image sensor or a complementary metal oxide semiconductor (CMOS) image sensor.

The imaging signal processing unit 23 performs predetermined signal processing on the imaging signal output from the imaging unit 22. For example, the imaging signal processing unit 23 performs various types of image processing on the image captured by the imaging unit 22. The imaging signal processing unit 23 outputs the imaging signal subjected to the above-described signal processing to the control device 3.

The control device 3 includes a processor, a memory, a storage, and the like for controlling various operations of the ranging system, and causes the ranging unit 31 to control, for example, distance measurement that is performed by the ranging system. For example, the ranging unit 31 controls the operation of the light source drive unit 11, and measures (calculates) the distance between the ranging system and the subject H on the basis of the imaging signal from the imaging signal processing unit 23. The distance measurement according to the present embodiment is performed by, for example, a time of flight (ToF) method, but may be performed by other methods. Furthermore, the control device 3 may be incorporated into either the light emitting device 1 or the light receiving device 2.

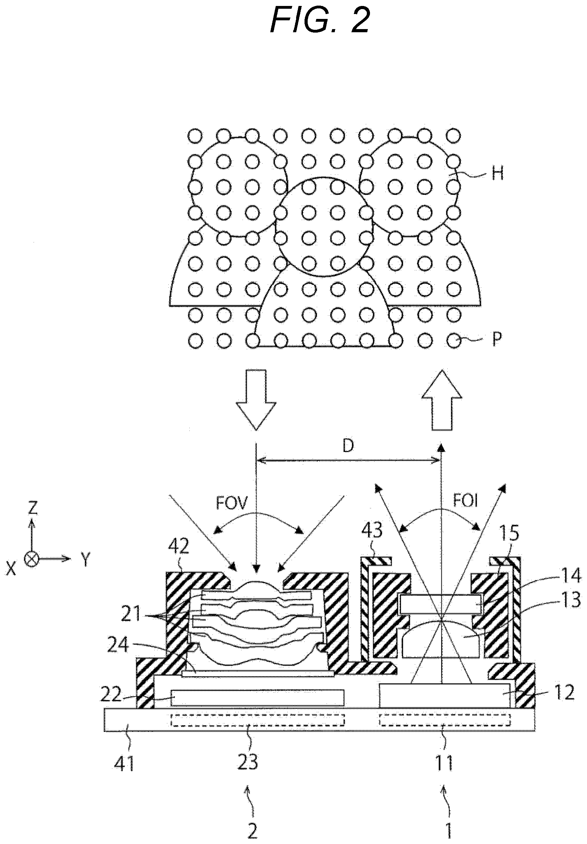

Fig. 2 is a cross-sectional view of structures of the light emitting device 1 and the light receiving device 2 according to the first embodiment.

The light emitting device 1 includes a holder 15 in addition to the light source drive unit 11, the light source 12, the collimating lens 13, and the diffractive optical element 14 described above. The holder 15 holds the collimating lens 13 and the diffractive optical element 14. The light from the light source 12 is emitted toward the subject H through the collimating lens 13 and the diffractive optical element 14. Fig. 2 illustrates a field of illumination (FoI) of the light emitted from the light emitting device 1.

The light receiving device 2 includes a filter 24 in addition to the lens unit 21, the imaging unit 22, and the imaging signal processing unit 23 described above. The filter 24 serves as a BPF that transmits light identical in wavelength to the light emitted from the light emitting device 1. The light reflected off the subject H passes through the lens unit 21 and the filter 24 to impinge on the imaging unit 22. Fig. 2 illustrates a field of view (FoV) of the light received by the light receiving device 1. Fig. 2 further illustrates a plurality of lenses included in the lens unit 21.

As illustrated in Fig. 2, the ranging system according to the present embodiment further includes a substrate 41, a first housing 42, and a second housing 43. According to the present embodiment, the light source drive unit 11 and the imaging signal processing unit 23 are provided inside the substrate 41, and the light source 12 and the imaging unit 22 are provided on a surface of the substrate 41. Note that at least one of the light source drive unit 11 or the imaging signal processing unit 23 may be provided in a place other than the inside of the substrate 41 (for example, the surface of the substrate 41) .

The first housing 42 is provided on the surface of the substrate 41 so as to cover the light source 12 and the imaging unit 22. The holder 15 is placed on a surface of the first housing 42, and the lens unit 21 and the filter 24 are held by the first housing 42. The second housing 43 is provided on the surface of first housing 42 so as to cover holder 15. The light from the light source 12 passes through an opening of the first housing 42 and an opening of the holder 15 to impinge on the collimating lens 13, and the light from the diffractive optical element 14 is emitted toward the subject H through the opening of the holder 15 and an opening of the second housing 43. On the other hand, the light reflected off the subject H passes through an opening of the first housing 42 to impinge on the lens unit 21.

Fig. 2 illustrates an X axis, a Y axis, and a Z axis orthogonal to each other. A Z direction is a direction from the ranging system according to the present embodiment toward the subject H, and an X direction and a Y direction are two directions orthogonal to the Z direction. For example, the X direction is a vertical direction (longitudinal direction), and the Y direction and the Z direction are horizontal directions (lateral directions). Fig. 2 schematically illustrates a state where the subject H is present in the horizontal direction (Z direction) of the ranging system according to the present embodiment. Therefore, in Fig. 2, the ranging system according to the present embodiment is used with the substrate 41 facing the Z direction. Note that the X direction may be a direction other than the vertical direction, or at least one of the Y direction or the Z direction may be a direction other than the horizontal direction.

As will be described later, the collimating lens 13, the diffractive optical element 14, and the holder 15 according to the present embodiment are driven in the X direction, and specifically, are driven in both a +X direction and a -X direction. This makes it possible to move the collimating lens 13, the diffractive optical element 14, and the holder 15 according to the present embodiment backward and forward in the X direction. One of the +X direction or the -X direction is an example of a first direction according to the present disclosure, and the other of the +X direction or the -X direction is an example of a direction opposite to the first direction according to the present disclosure. Note that the light emitting device 1 according to the present embodiment need not include the diffractive optical element 14, and in that case, the collimating lens 13 and the holder 15 are driven in the X direction.

Furthermore, the light receiving device 2 according to the present embodiment is disposed in a -Y direction of the light emitting device 1. If the light receiving device 2 is disposed in the +X direction or the -X direction of the light emitting device 1, the light receiving device 2 may interfere with the driving of the holder 15 when the holder 15 is driven in the +X direction or the -X direction. According to the present embodiment, disposing the light receiving device 2 in the -Y direction of the light emitting device 1 makes it possible to prevent the light receiving device 2 from interfering with the driving of the holder 15. Note that the light receiving device 2 may be disposed in a +Y direction of the light emitting device 1. The +Y direction or the -Y direction is an example of a second direction according to the present disclosure.

Fig. 2 illustrates examples of a plurality of ranging points P for measuring the distance to the subject H. The ranging system according to the present embodiment measures the distance to the subject H by irradiating the ranging points P with the light from the plurality of light emitting elements described above. At this time, the ranging system according to the present embodiment irradiates the ranging points P with the light sequentially rather than simultaneously.

For example, the ranging system according to the present embodiment causes all the light emitting elements of the light source 12 to generate light and simultaneously irradiates part of the ranging points P illustrated in Fig. 2 with the light. Next, the holder 15 is driven in the +X direction or the -X direction to change an irradiation position of the light from the light source 12. This makes it possible to change the ranging points P irradiated with the light from the light source 12. Therefore, when the ranging system according to the present embodiment again causes all the light emitting elements of the light source 12 to generate light, another part of the ranging points P illustrated in Fig. 2 is simultaneously irradiated with the light. The ranging system according to the present embodiment alternately repeats the generation of the light and the driving of the holder 15 described above. This makes it possible to sequentially irradiate all the ranging points P illustrated in Fig. 2 with the light. According to the present embodiment, it is possible to irradiate a large number of ranging points P with the light using a small number of light emitting elements.

According to the present embodiment, the light propagates from the light source 12 to the subject H in approximately the Z direction. Therefore, when the holder 15 is driven in the +X direction or the -X direction, the irradiation position of the light also moves in the +X direction or the -X direction, and the ranging points P irradiated with the light also move in the +X direction or the -X direction. That is, a moving direction of the irradiation position of the light according to the present embodiment coincides with a moving direction of the holder 15. The moving direction of the irradiation position of the light according to the present embodiment, however, need not coincide with the moving direction of the holder 15. For example, in a case where the subject H is irradiated with the light from the light source 12 through a reflector or a prism, such directions do not generally coincide with each other. In the following description, for the sake of easy understanding of the description, a case where the directions coincide with each other will be described, but the following description is also applicable to a case where the directions do not coincide with each other.

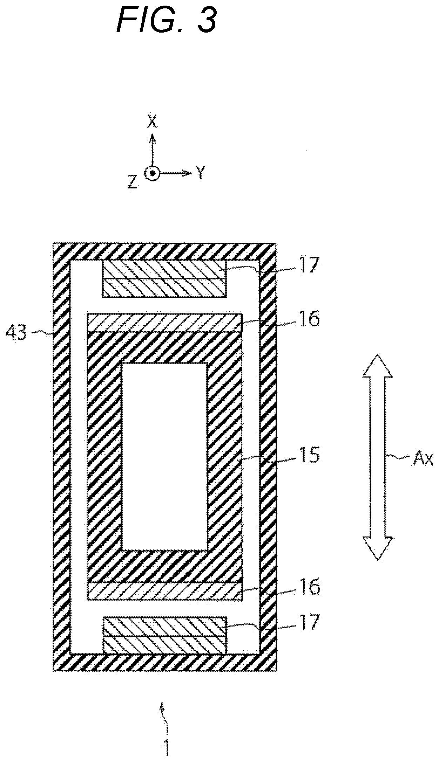

Fig. 3 is a cross-sectional view of a structure of the light emitting device 1 according to the first embodiment.

Fig. 3 illustrates an XY cross section of the holder 15 and the second housing 43 surrounding the holder 15 of the light emitting device 1. As illustrated in Fig. 3, the light emitting device 1 includes two coils 16 provided on the holder 15, and two magnets 17 provided on the second housing 43 so as to face the coils 16. One of the magnets 17 is disposed in the +X direction of a corresponding coil 16, and the other magnet 17 is disposed in the -X direction of a corresponding coil 16.

An arrow Ax illustrated in Fig. 3 indicates a driving direction of the holder 15. The driving direction of the holder 15 according to the present embodiment is a ±X direction. The coils 16 and the magnets 17 according to the present embodiment can drive the holder 15 in the ±X direction using an electromagnetic force acting between the coil 16 and the magnet 17 corresponding to each other. When the holder 15 is driven in the ±X direction, the collimating lens 13 and the diffractive optical element 14 held by the holder 15 are also driven in the ±X direction. As a result, the irradiation position of the light emitted from the light source 12 to the subject H moves in the ±X direction. The coils 16 and the magnets 17 correspond to an example of a moving unit according to the present disclosure, and the collimating lens 13, the diffractive optical element 14, and the holder 15 correspond to an example of a predetermined portion driven by the moving unit according to the present disclosure. How the coils 16 and the magnets 17 operate may be controlled by a control unit of the light emitting device 1, or may be controlled by a control unit (for example, the ranging unit 31 of the control device 3) other than the light emitting device 1.

The above-described moving unit may include a mechanism other than the coils 16 and the magnets 17. For example, the above-described moving unit may be implemented via piezo driving, and specifically, the holder 15 and the like may be driven by a piezoelectric element (piezo element) that expands and contracts when a voltage is applied. Furthermore, the above-described moving unit may be implemented via SMA shape memory, and specifically, the holder 15 and the like may be driven by deformation of a shape-memory alloy, the deformation being made by energization that changes an ambient temperature of the shape-memory alloy. Furthermore, the above-described predetermined portion driven by the above-described moving unit may be an optical system including the collimating lens 13 and/or the diffractive optical element 14, or may be the light source 12 rather than the optical system.

The light emitting device 1 according to the present embodiment includes only two sets of the coils 16 and the magnets 17, and includes the coils 16 and the magnets 17 only in the ±X direction of the holder 15 out of the ±X direction and a ±Y direction of the holder 15. Therefore, the light emitting device 1 according to the present embodiment can drive the holder 15 only in the ±X direction out of the ±X direction and the ±Y direction. In other words, the holder 15 according to the present embodiment is driven along one axis in the ±X direction rather than along two axes in the ±X direction and the ±Y direction. According to the present embodiment, providing the coils 16 and the magnets 17 only in the ±X direction of the holder 15 allows a reduction in size of the light emitting device 1 and the ranging system in the Y direction.

The light emitting device 1 according to the present embodiment drives the collimating lens 13, the diffractive optical element 14, and the holder 15 in the ±X direction. According to the present embodiment, driving the collimating lens 13 and the diffractive optical element 14 in the ±X direction makes it possible to not only move the irradiation position of the light in the ±X direction, but also change, for example, the distance to the subject H, the resolution of the distance measurement, and the range of the distance measurement. Note that the light emitting device 1 according to the present embodiment may drive only some of the collimating lens 13, the diffractive optical element 14, and the holder 15 in the ±X direction, or may drive a different component (for example, the light source 12) of the light emitting device 1 in the ±X direction.

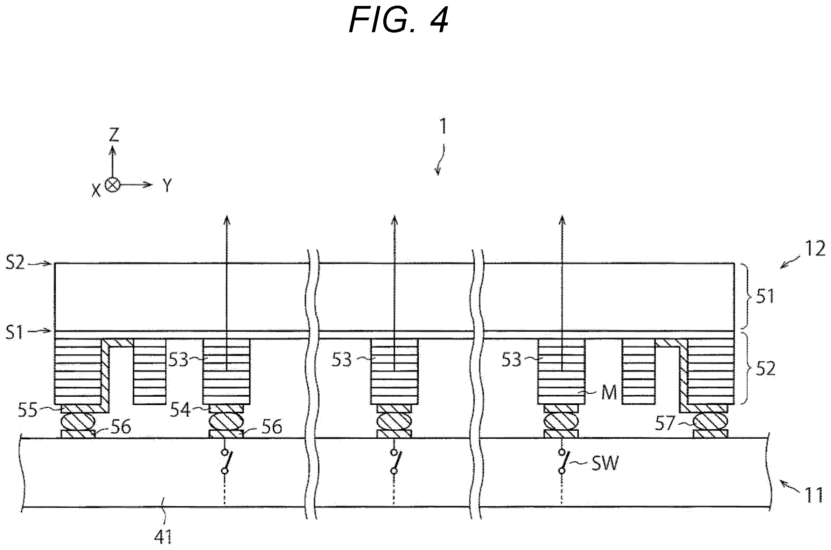

Fig. 4 is another cross-sectional view of the structure of the light emitting device 1 according to the first embodiment.

Fig. 4 illustrates a YZ cross section of the light source drive unit 11 and the light source 12 of the light emitting device 1. As described above, the light source drive unit 11 is provided inside the substrate 41, and the light source 12 is provided on the surface of the substrate 41. As illustrated in Fig. 4, the light source 12 includes a substrate 51, a laminated film 52, a plurality of light emitting elements 53, a plurality of anode electrodes 54, and a plurality of cathode electrodes 55. The light emitting device 1 further includes a plurality of connection pads 56 provided on the surface of the substrate 41, and a plurality of bumps 57 provided between the anode electrodes 54 and the connection pads 56 and between the cathode electrodes 55 and the connection pads 56.

The substrate 51 is, for example, a compound semiconductor substrate such as a gallium arsenide (GaAs) substrate. Fig. 4 illustrates a front surface S1 of the substrate 51 facing a -Z direction and a back surface S2 of the substrate 51 facing a +Z direction. The front surface S1 is an example of a first surface according to the present disclosure, and the back surface S2 is an example of a second surface according to the present disclosure.

The laminated film 52 includes a plurality of layers laminated on the front surface S1 of the substrate 51. Examples of such layers include an n-type semiconductor layer, an active layer, a p-type semiconductor layer, a light reflecting layer, an insulating layer having a light exit window, and the like. The laminated film 52 includes a plurality of mesa portions M extending in the -Z direction. Some of the mesa portions M serve as the above-described plurality of light emitting elements 53.

The light emitting elements 53 are provided on the front surface S1 of the substrate 51 as a part of the laminated film 52. The light emitting elements 53 according to the present embodiment each have a VCSEL structure and emit light in the +Z direction. As illustrated in Fig. 4, the light emitted from the light emitting elements 53 passes through the substrate 51 from the front surface S1 to the back surface S2 to exit from the substrate 51 to the collimating lens 13. As described above, the light source 12 according to the present embodiment is a back-illuminated VCSEL chip.

The anode electrodes 54 are each provided at an end of a corresponding light emitting element 53. The cathode electrodes 55 are each provided at an end of a corresponding mesa portion M other than the light emitting elements 53, and extends from the end of the mesa portion M to the surface of the laminated film 52 between the mesa portions M. Each light emitting element 53 emits light when a current flows between a corresponding anode electrode 54 and a corresponding cathode electrode 55.

The light source 12 is disposed on the surface of the substrate 41 with the bumps 57 and the connection pads 56 interposed between the light source 12 and the surface of the substrate 41, and is electrically connected to the light source drive unit 11 via the bumps 57 and the connection pads 56. The connection pads 56 include, for example, copper (Cu). The bumps 57 include, for example, gold (Au). The light emitting device 1 may include solder rather than the bumps 57.

Fig. 4 schematically illustrates one or more switches SW included in the light source drive unit 11. Such switches SW are each electrically connected to a corresponding light emitting elements 53 via the bump 57. The light source drive unit 11 according to the present embodiment can drive (turn on/off) the above-described plurality of light emitting elements 53 by controlling (turning on/off) the switches SW. Note that the switches SW may correspond to the light emitting elements 53 on a one-to-one basis, or need not correspond to the light emitting elements 53 on a one-to-one basis.

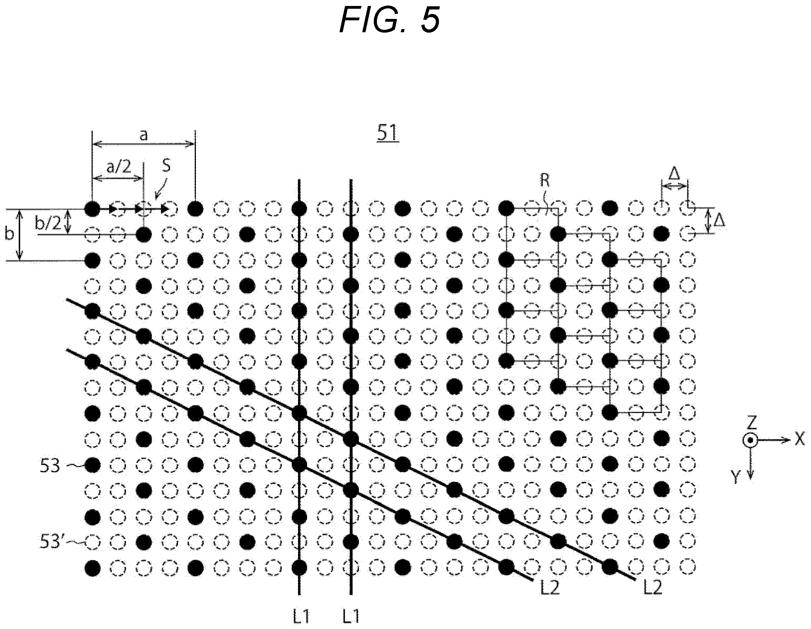

Fig. 5 is a plan view of an arrangement example of the light emitting elements 53 according to the first embodiment.

Fig. 5 illustrates the plurality of light emitting elements 53 arranged in a two-dimensional array on the front surface S1 of the substrate 51. In Fig. 5, such light emitting elements 53 are indicated by filled circles, and a plurality of portions 53' where no light emitting element 53 is present are indicated by dashed open circles. If all the filled circles and the open circles represent the light emitting elements 53, the light emitting elements 53 are arranged in a square lattice with a lattice constant Δ. According to the present embodiment, however, only the filled circles represent the light emitting elements 53, and the light emitting elements 53 are arranged in a triangular lattice. Triangles constituting the triangular lattice according to the present embodiment are uniform in shape, and as a result, density of the light emitting elements 53 on the front surface S1 of the substrate 51 become uniform. Fig. 5 illustrates 90 (6 * 8 + 6 * 7) light emitting elements 53.

The light emitting elements 53 according to the present embodiment are arranged at intersections of a plurality of first straight lines L1 extending in the Y direction and a plurality of second straight lines L2 extending in a direction parallel to neither the X direction nor the Y direction. As a result, the light emitting elements 53 according to the present embodiment are arranged in a parallelogram lattice. The above-described triangular lattice is obtained by dividing each parallelogram into two. The direction in which the second straight lines L2 extends is an example of a third direction according to the present disclosure.

In Fig. 5, two first straight lines L1 adjacent to each other among the above-described plurality of first straight lines L1 and two second straight lines L2 adjacent to each other among the above-described plurality of second straight lines L2 are indicated by solid lines. The two first straight lines L1 extend in the Y direction and are adjacent to each other in the X direction. The two first straight lines L1 are examples of a straight line A and a straight line B according to the present disclosure.

According to the present embodiment, the light emitting elements 53 on the two first straight lines L1 are arranged so as not to be adjacent to each other in the X direction. For example, eight light emitting elements 53 (filled circles) on the left first straight line L1 are each adjacent to a corresponding one of eight open circles on the right first straight line L1 in the X direction. Similarly, eight light emitting elements 53 (filled circles) on the right first straight line L1 are each adjacent to a corresponding one of eight open circles on the left first straight line L1 in the X direction. Therefore, on the two first straight lines L1, none of the 16 light emitting elements 53 is adjacent to the other light emitting elements 53 in the X direction. The same applies to first straight lines L1 other than the two first straight lines L1 indicated by the solid lines.

As a result, the light emitting elements 53 on each first straight line L1 according to the present embodiment are not continuously arranged in the Y direction. On each first straight line L1, the light emitting elements 53 adjacent to each other in the Y direction are arranged so as to place one open circle between the light emitting elements 53. Therefore, a pitch b between the light emitting elements 53 adjacent to each other in the Y direction is 2 * Δ (b = 2 * Δ). On the other hand, the light emitting elements 53 adjacent to each other in the X direction are arranged so as to place one first straight line L1 between the light emitting elements 53. Therefore, a pitch a between the light emitting elements 53 adjacent to each other in the X direction is 2² * Δ, that is, 4 * Δ (a = 4 * Δ).

Fig. 5 further illustrates a plurality of regions R on the front surface S1 of the substrate 51. Each of the regions R indicates a region provided for each light emitting element 53. Each of the regions R is square with a side length of 2 * Δ.

Fig. 5 further illustrates "a/2" that is a minimum pitch in the X direction between the light emitting elements 53 provided on the front surface S1 of the substrate 51, and "b/2" that is a minimum pitch in the Y direction between the light emitting elements 53 provided on the front surface S1 of the substrate 51. A relation of a = 4 * Δ is established, so that the minimum pitch "a/2" between the light emitting elements 53 in the X direction is 2 * Δ. Similarly, a relation of b = 2 * Δ is established, so that the minimum pitch "b/2" between the light emitting elements 53 in the Y direction is Δ.

As described above, the light emitting device 1 according to the present embodiment can sequentially irradiate all the ranging points P illustrated in Fig. 2 with the light by alternately repeating the generation of the light from the light emitting elements 53 and the driving of the holder 15. At this time, the light emitting device 1 according to the present embodiment may perform the operation of driving the holder 15 in the +X direction 2² - 1 times, that is, three times. This makes it possible to change the irradiation position of the light in a similar manner to a case where the light emitting elements 53 are moved as indicated by an arrow S illustrated in Fig. 5. The arrow S illustrated in Fig. 5 indicates a state where the operation of moving the light emitting elements 53 by Δ in the +X direction is performed three times. In this case, it is possible to irradiate the subject H with the light in a similar manner to a case where the filled circles and the open circles all represent the light emitting elements 53. Therefore, according to the present embodiment, it is possible to efficiently irradiate a large number of ranging points P with the light using a small number of light emitting elements.

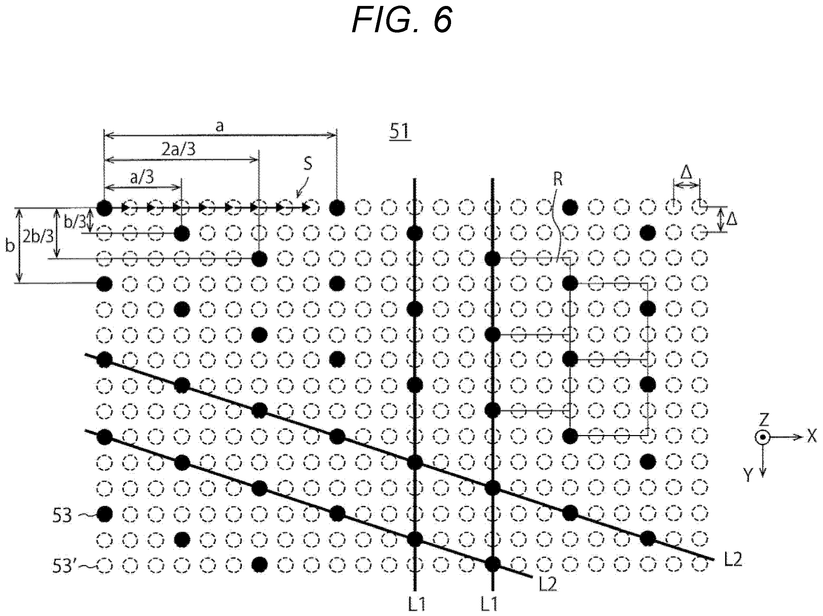

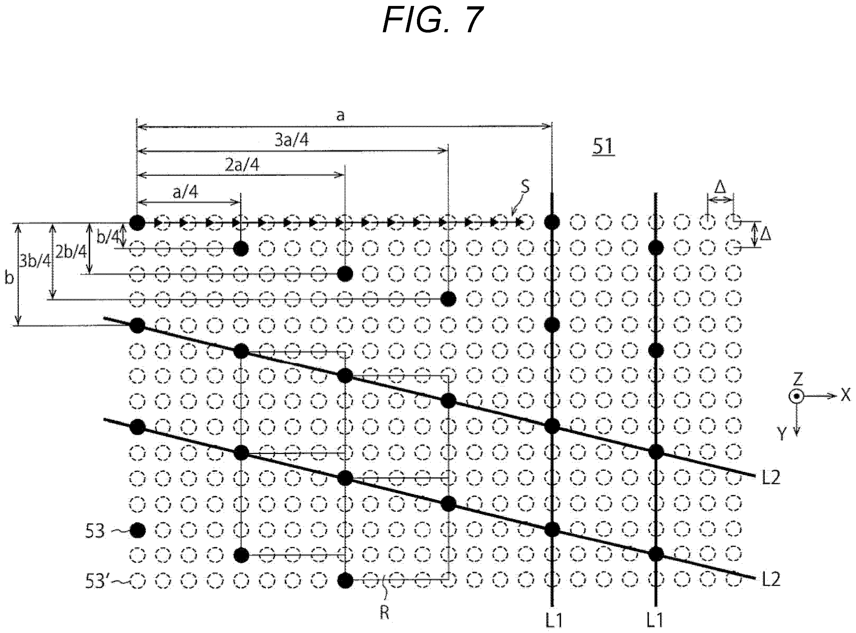

The light emitting elements 53 according to the present embodiment may be arranged such that each region R becomes square with a side length of N * Δ (where N is an integer greater than or equal to 2). In this case, the pitch b between the light emitting elements 53 adjacent to each other in the Y direction is N * Δ (b = N * Δ), and the pitch a between the light emitting elements 53 adjacent to each other in the X direction is N² * Δ (a = N² * Δ). Moreover, the minimum pitch between the light emitting elements 53 in the X direction is N * Δ, and the minimum pitch between the light emitting elements 53 in the Y direction is Δ. Hereinafter, a case where N = 3 will be described with reference to Fig. 6, and a case where N = 4 will be described with reference to Fig. 7.

Fig. 6 is a plan view of another arrangement example of the light emitting elements 53 according to the first embodiment. Fig. 6 illustrates 40 (8 * 5) light emitting elements 53.

On each first straight line L1 illustrated in Fig. 6, the light emitting elements 53 adjacent to each other in the Y direction are arranged so as to place two open circles between the light emitting elements 53. Therefore, the pitch b between the light emitting elements 53 adjacent to each other in the Y direction is 3 * Δ (b = 3 * Δ). On the other hand, the light emitting elements 53 adjacent to each other in the X direction are arranged so as to place two first straight lines L1 between the light emitting elements 53. Therefore, the pitch a between the light emitting elements 53 adjacent to each other in the X direction is 3² * Δ, that is, 9 * Δ (a = 9 * Δ). Moreover, each region R is square with a side length of 3 * Δ.

Fig. 6 further illustrates "a/3" that is the minimum pitch in the X direction between the light emitting elements 53 provided on the front surface S1 of the substrate 51, and "b/3" that is the minimum pitch in the Y direction between the light emitting elements 53 provided on the front surface S1 of the substrate 51. A relation of a = 9 * Δ is established, so that the minimum pitch "a/3" between the light emitting elements 53 in the X direction between is 3 * Δ. Similarly, a relation of b = 3 * Δ is established, so that the minimum pitch "b/3" between the light emitting elements 53 in the Y direction is Δ.

As described above, the light emitting device 1 according to the present embodiment can sequentially irradiate all the ranging points P illustrated in Fig. 2 with the light by alternately repeating the generation of the light from the light emitting elements 53 and the driving of the holder 15. At this time, the light emitting device 1 according to the present embodiment may perform the operation of driving the holder 15 in the +X direction 3² - 1 times, that is, eight times. This makes it possible to change the irradiation position of the light in a similar manner to a case where the light emitting elements 53 are moved as indicated by an arrow S illustrated in Fig. 6. The arrow S illustrated in Fig. 6 indicates a state where the operation of moving the light emitting elements 53 by Δ in the +X direction is performed eight times. In this case, it is possible to irradiate the subject H with the light in a similar manner to a case where the filled circles and the open circles all represent the light emitting elements 53. Therefore, according to the present embodiment, it is possible to efficiently irradiate a large number of ranging points P with the light using a small number of light emitting elements.

Fig. 7 is a plan view of another arrangement example of the light emitting elements 53 according to the first embodiment. Fig. 7 illustrates 23 (5 * 4 + 1 * 3) light emitting elements 53.

On each first straight line L1 illustrated in Fig. 7, the light emitting elements 53 adjacent to each other in the Y direction are arranged so as to place three open circles between the light emitting elements 53. Therefore, the pitch b between the light emitting elements 53 adjacent to each other in the Y direction is 4 * Δ (b = 4 * Δ). On the other hand, the light emitting elements 53 adjacent to each other in the X direction are arranged so as to place three first straight lines L1 between the light emitting elements 53. Therefore, the pitch a between the light emitting elements 53 adjacent to each other in the X direction is 4² * Δ, that is, 16 * Δ (a = 16 * Δ). Moreover, each region R is square with a side length of 4 * Δ.

Fig. 7 further illustrates "a/4" that is the minimum pitch in the X direction between the light emitting elements 53 provided on the front surface S1 of the substrate 51, and "b/4" that is the minimum pitch in the Y direction between the light emitting elements 53 provided on the front surface S1 of the substrate 51. A relation of a = 16 * Δ is established, so that the minimum pitch "a/4" between the light emitting elements 53 in the X direction is 4 * Δ. Similarly, a relation of b = 4 * Δ is established, so that the minimum pitch "b/4" between the light emitting elements 53 in the Y direction is Δ.

As described above, the light emitting device 1 according to the present embodiment can sequentially irradiate all the ranging points P illustrated in Fig. 2 with the light by alternately repeating the generation of the light from the light emitting elements 53 and the driving of the holder 15. At this time, the light emitting device 1 according to the present embodiment may perform the operation of driving the holder 15 in the +X direction 4² - 1 times, that is, 15 times. This makes it possible to change the irradiation position of the light in a similar manner to a case where the light emitting elements 53 are moved as indicated by an arrow S illustrated in Fig. 7. The arrow S illustrated in Fig. 7 indicates a state where the operation of moving the light emitting elements 53 by Δ in the +X direction is performed 15 times. In this case, it is possible to irradiate the subject H with the light in a similar manner to a case where the filled circles and the open circles all represent the light emitting elements 53. Therefore, according to the present embodiment, it is possible to efficiently irradiate a large number of ranging points P with the light using a small number of light emitting elements.

Note that, in a case where the light emitting elements 53 according to the present embodiment are arranged such that each region R is square with a side length of N * Δ, the operation of driving the holder 15 in the +X direction is performed, for example, N² - 1 times.

N according to the present embodiment may be set at any value. Setting N at a large value brings about an advantage that, for example, the number of light emitting elements 53 can be reduced. The reduction in the number of the light emitting elements 53 allows a reduction in size of the light source 12, for example. On the other hand, setting N at a large value brings about an advantage that, for example, the number of times of driving the holder 15 can be reduced. The reduction in the number of times of driving the holder 15 allows a reduction in time required for distance measurement, for example.

Note that the light emitting elements 53 according to the present embodiment may be arranged at positions other than the intersections of the plurality of first straight lines L1 extending in the Y direction and the plurality of second straight lines L2 extending in the direction parallel to neither the X direction nor the Y direction. For example, the light emitting elements 53 according to the present embodiment may be arranged at intersections of a plurality of first curves identical in shape to each other and a plurality of second curves identical in shape to each other but different from the first curves. This makes it possible to achieve a pitch relation similar to the respective pitches illustrated in Figs. 5, 6, and 7, for example. The density of the light emitting elements 53 on the front surface S1 of the substrate 51 may be uniform or non-uniform, but is desirably uniform.

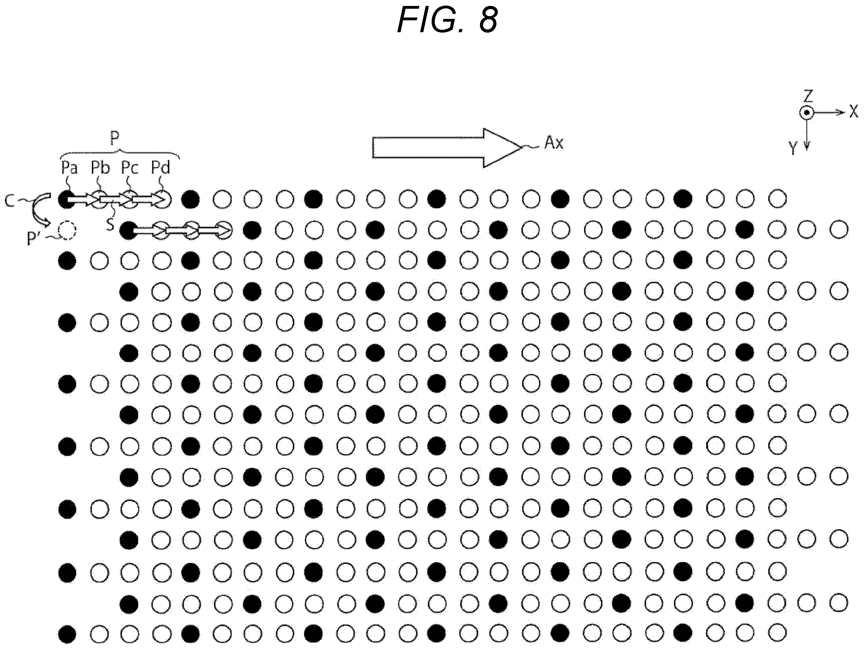

Fig. 8 is a plan view for describing an operation example of the light emitting elements 53 illustrated in Fig. 5.

Fig. 8 illustrates a plurality of ranging points P for measuring the distance to the subject H using the light emitting elements 53 illustrated in Fig. 5. In this case, the operation of causing the light emitting elements 53 to emit light is performed four times, and the operation of driving the holder 15 in the +X direction is performed three times, both the operations being alternately performed.

The ranging points P illustrated in Fig. 8 include ranging points Pa to Pd that are irradiated with the light by first to fourth light emissions. In Fig. 8, the ranging points Pa are indicated by filled circles, and the ranging points Pb to Pd are indicated by solid open circles. The ranging points Pa illustrated in Fig. 8 are identical in layout to the light emitting elements 53 illustrated in Fig. 5. The same applies to the layout of the ranging points Pb to Pd. Fig. 8 further illustrates an example of a portion P' where no ranging point P is present indicated by a dashed open circle. An arrow C illustrated in Fig. 8 indicates that one dashed open circle is present between the ranging points Pa adjacent to each other in the Y direction.

The light emitting device 1 according to the present embodiment can sequentially irradiate all the ranging points Pa to Pd illustrated in Fig. 8 with the light as indicated by an arrow S by alternately repeating the generation of the light from the light emitting elements 53 and the driving of the holder 15. In a case where the ranging points Pa to Pd are present on the same XY plane, it is possible to achieve the ranging points Pa to Pd in a square lattice as illustrated in Fig. 8 according to the present embodiment. The number of ranging points Pa to Pd illustrated in Fig. 8 is 360 (90 * 4).

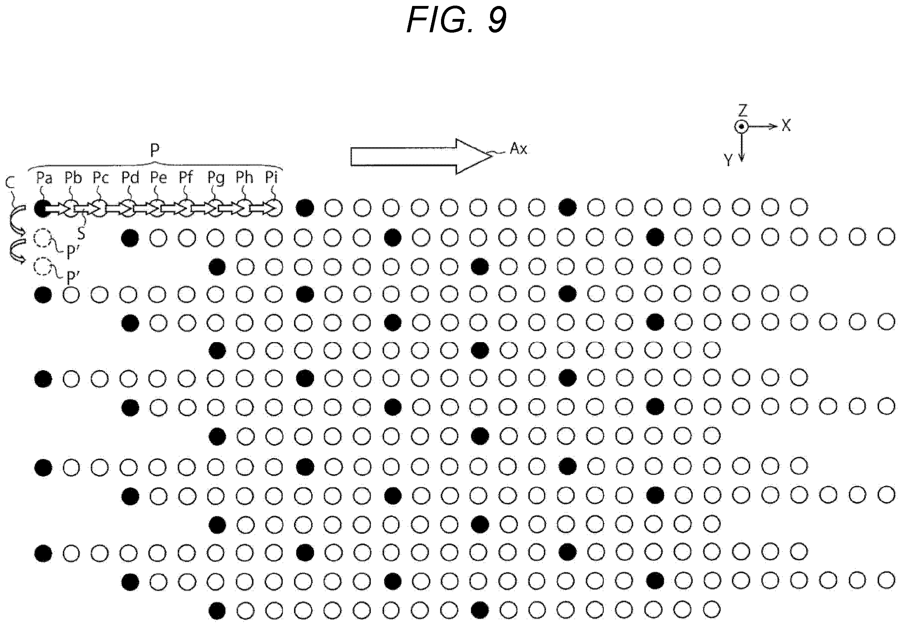

Fig. 9 is a plan view for describing an operation example of the light emitting elements 53 illustrated in Fig. 6.

Fig. 9 illustrates a plurality of ranging points P for measuring the distance to the subject H using the light emitting elements 53 illustrated in Fig. 6. In this case, the operation of causing the light emitting elements 53 to emit light is performed nine times, and the operation of driving the holder 15 in the +X direction is performed eight times, both the operations being alternately performed.

The ranging points P illustrated in Fig. 9 include ranging points Pa to Pi that are irradiated with the light by first to ninth light emissions. In Fig. 9, the ranging points Pa are indicated by filled circles, and the ranging points Pb to Pi are indicated by solid open circles. The ranging points Pa illustrated in Fig. 9 are identical in layout to the light emitting elements 53 illustrated in Fig. 6. The same applies to the layout of the ranging points Pb to Pi. Fig. 9 further illustrates an example of a portion P' where no ranging point P is present indicated by a dashed open circle. An arrow C illustrated in Fig. 9 indicates that two dashed open circles are present between the ranging points Pa adjacent to each other in the Y direction.

The light emitting device 1 according to the present embodiment can sequentially irradiate all the ranging points Pa to Pi illustrated in Fig. 9 with the light as indicated by an arrow S by alternately repeating the generation of the light from the light emitting elements 53 and the driving of the holder 15. In a case where the ranging points Pa to Pi are present on the same XY plane, it is possible to achieve the ranging points Pa to Pi in a square lattice as illustrated in Fig. 9 according to the present embodiment. The number of ranging points Pa to Pi illustrated in Fig. 9 is 360 (40 * 9).

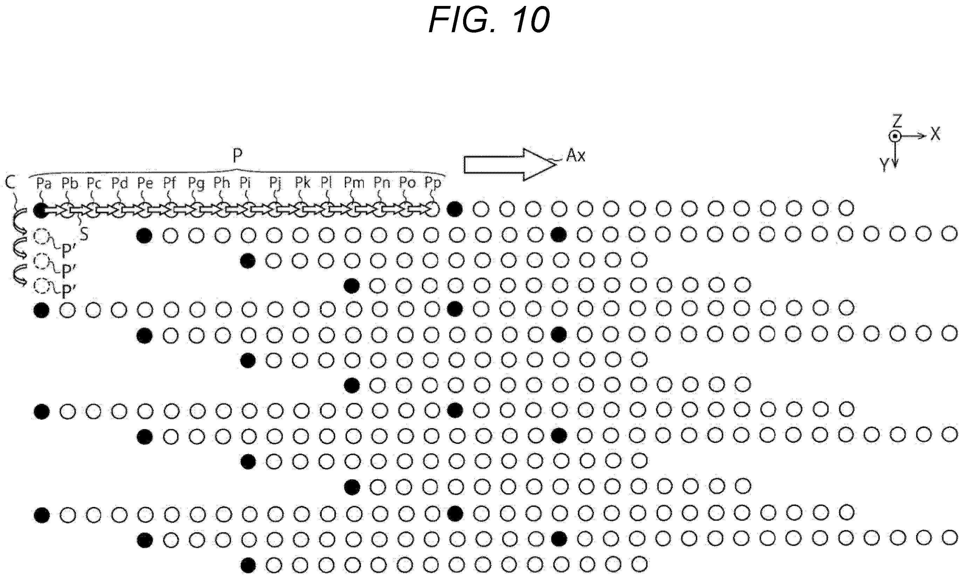

Fig. 10 is a plan view for describing an operation example of the light emitting elements 53 illustrated in Fig. 7.

Fig. 10 illustrates a plurality of ranging points P for measuring the distance to the subject H using the light emitting elements 53 illustrated in Fig. 7. In this case, the operation of causing the light emitting elements 53 to emit light is performed 16 times, and the operation of driving the holder 15 in the +X direction is performed 15 times, both the operations being alternately performed.

The ranging points P illustrated in Fig. 10 include ranging points Pa to Pp that are irradiated with the light by first to sixteenth light emissions. In Fig. 10, the ranging points Pa are indicated by filled circles, and the ranging points Pb to Pp are indicated by solid open circles. The ranging points Pa illustrated in Fig. 10 are identical in layout to the light emitting elements 53 illustrated in Fig. 7. The same applies to the layout of the ranging points Pb to Pp. Fig. 10 further illustrates an example of a portion P' where no ranging point P is present indicated by a dashed open circle. An arrow C illustrated in Fig. 10 indicates that three dashed open circles are present between the ranging points Pa adjacent to each other in the Y direction.

The light emitting device 1 according to the present embodiment can sequentially irradiate all the ranging points Pa to Pp illustrated in Fig. 10 with the light as indicated by an arrow S by alternately repeating the generation of the light from the light emitting elements 53 and the driving of the holder 15. In a case where the ranging points Pa to Pp are present on the same XY plane, it is possible to achieve the ranging points Pa to Pp in a square lattice as illustrated in Fig. 10 according to the present embodiment. The number of ranging points Pa to Pp illustrated in Fig. 10 is 368 (23 * 16).

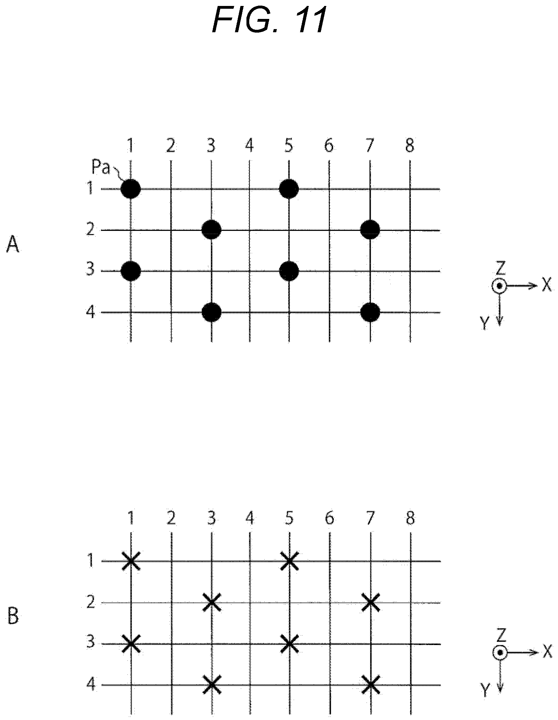

Figs. 11 to 14 are plan views for describing details of the operation example of the light emitting elements 53 illustrated in Fig. 5.

A of Fig. 11 illustrates the ranging points Pa that are irradiated with the light by the first light emission. B of Fig. 11 illustrates the portions irradiated with the light by the first light emission, each of the portions being indicated by X. Xs illustrated in B of Fig. 11 are identical in layout to the ranging points Pa illustrated in A of Fig. 11.

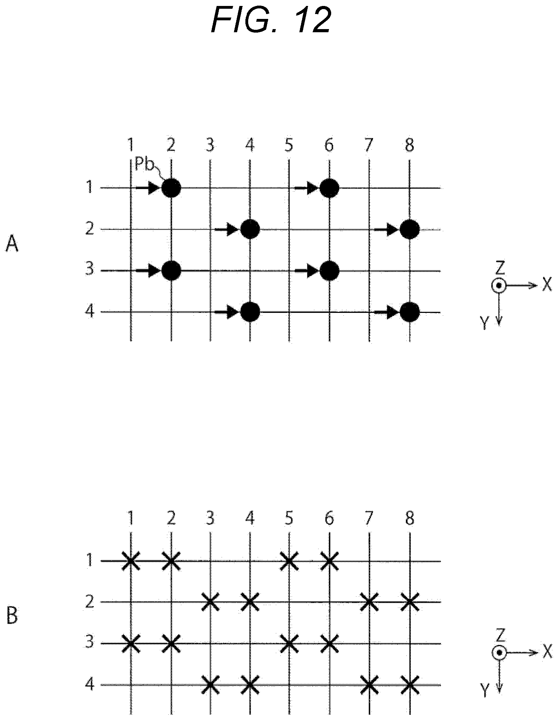

A of Fig. 12 illustrates the ranging points Pb that are irradiated with the light by the second light emission. An arrow illustrated in A of Fig. 12 indicates a state where portions to be irradiated with the light move to the ranging points Pb. B of Fig. 12 illustrates the portions irradiated with the light by the first and second light emissions, each of the portions being indicated by X. The number of Xs illustrated in B of Fig. 12 is twice the number of Xs illustrated in B of Fig. 11.

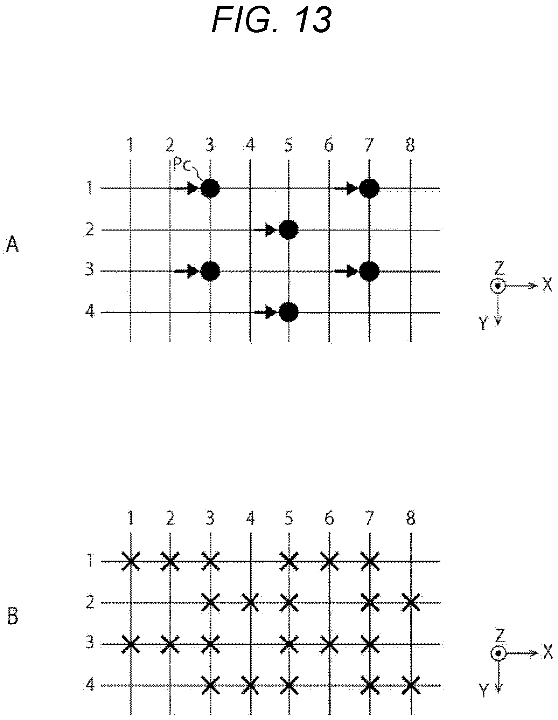

A of Fig. 13 illustrates the ranging points Pc that are irradiated with the light by the third light emission. An arrow illustrated in A of Fig. 13 indicates a state where portions to be irradiated with the light move to the ranging points Pc. B of Fig. 13 illustrates the portions irradiated with the light by the first to third light emissions, each of the portions being indicated by X. The number of Xs illustrated in B of Fig. 13 is three times the number of Xs illustrated in B of Fig. 11, including Xs outside the drawing.

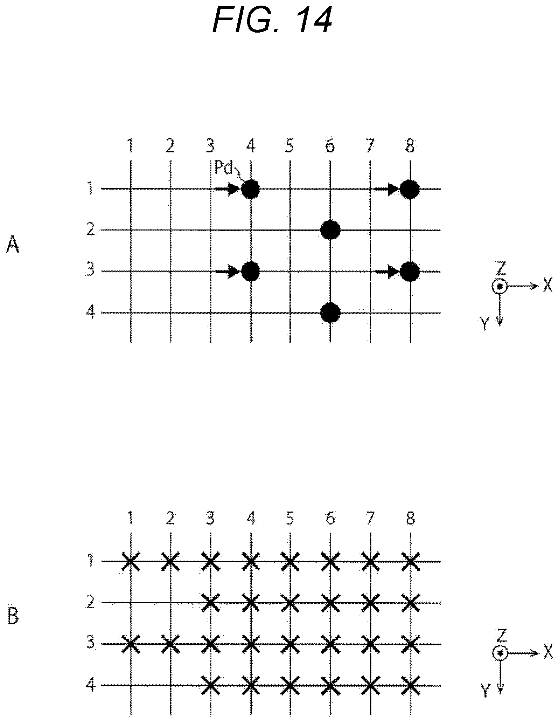

A of Fig. 14 illustrates the ranging points Pd that are irradiated with the light by the fourth light emission. An arrow illustrated in A of Fig. 14 indicates a state where portions to be irradiated with the light move to the ranging points Pd. B of Fig. 14 illustrates the portions irradiated with the light by the first to fourth light emissions, each of the portions being indicated by X. The number of Xs illustrated in B of Fig. 14 is four times the number of Xs illustrated in B of Fig. 11, including Xs outside the drawing.

According to the present embodiment, as illustrated in B of Fig. 14, it is possible to achieve the ranging points (Xs) in a square lattice.

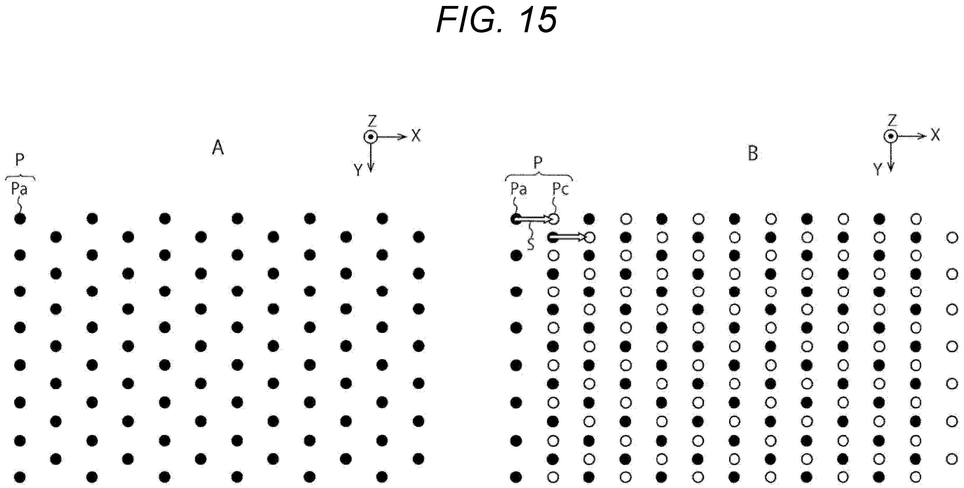

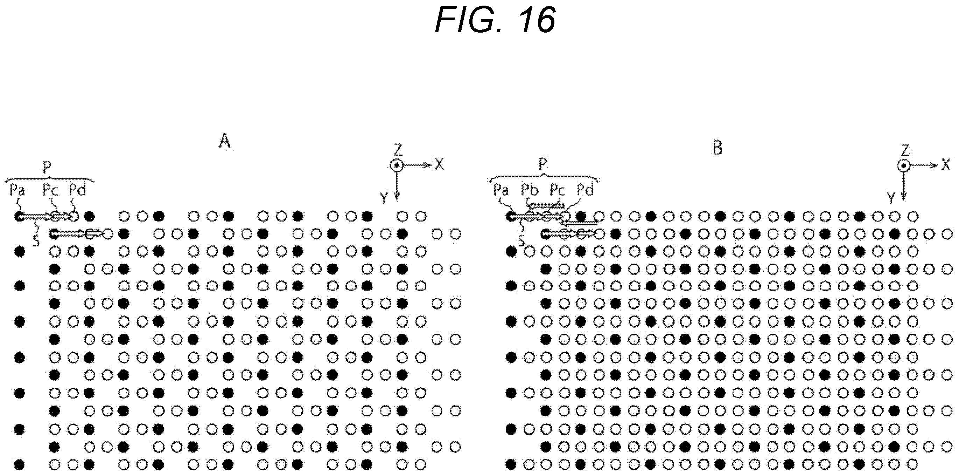

Figs. 15 and 16 are plan views for describing another operation example of the light emitting elements 53 illustrated in Fig. 5.

A of Fig. 15 illustrates the ranging points Pa that are irradiated with the light by the first light emission. B of Fig. 15 illustrates the ranging points Pc that are irradiated with the light by the second light emission. An arrow S illustrated in B of Fig. 15 indicates a state where portions to be irradiated with the light move from the ranging points Pa to the ranging points Pc in the +X direction. This can be achieved by driving the holder 15 in the +X direction.

A of Fig. 16 illustrates the ranging points Pd that are irradiated with the light by the third light emission. An arrow S additionally illustrated in A of Fig. 16 indicates a state where portions to be irradiated with the light move from the ranging points Pc to the ranging points Pd in the +X direction. This can be achieved by driving the holder 15 in the +X direction.

B of Fig. 16 illustrates the ranging points Pb that are irradiated with the light by the fourth light emission. An arrow S additionally illustrated in B of Fig. 16 indicates a state where portions to be irradiated with the light move from the ranging points Pd to the ranging points Pb in the -X direction. This can be achieved by driving the holder 15 in the -X direction.

According to the example illustrated in A of Fig. 15 to B of Fig. 16, the same ranging points Pa to Pb as the ranging points Pa to Pd illustrated in Fig. 8 can be achieved by driving the holder 15 in the ±X direction. According to this example, bringing the light emission to an end only with the first and second light emissions makes it possible to obtain an image with half the resolution of an image obtained in a case where the first to fourth light emissions are performed. According to this example, it is therefore possible to obtain a low-resolution image in a short time. Note that, according to this example, bringing the light emission to an end only with the first light emission makes it possible to obtain an image with one fourth of the resolution of the image obtained in a case where the first to fourth light emissions are performed.

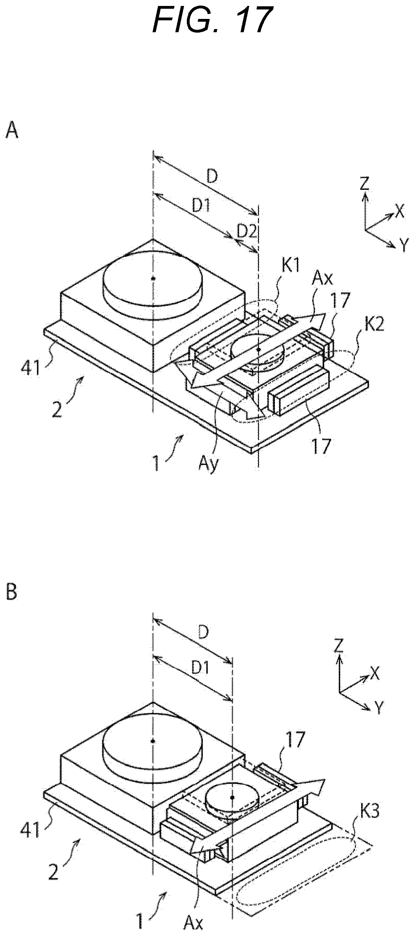

Fig. 17 is a perspective view for describing details of the light emitting device 1 according to the first embodiment.

A of Fig. 17 illustrates a light emitting device 1 according to a comparative example of the present embodiment. The light emitting device 1 according to the present comparative example includes four sets of coils 16 and magnets 17 in the ±X direction and the ±Y direction of the holder 15. Therefore, the light emitting device 1 according to the present comparative example can drive the holder 15 in the ±X direction and the ±Y direction as indicated by arrows Ax and Ay. In other words, the holder 15 according to the present comparative example is driven along two axes, that is, in the ±X direction and the ±Y direction.

A of Fig. 17 further illustrates a distance D (referred to as a baseline length) between a center axis of the light emitting device 1 and a center axis of the light receiving device 2, a space K1 provided in the -Y direction of the light emitting device 1, and a space K2 provided in the +Y direction of the light emitting device 1. According to the present comparative example, the holder 15 is driven in the ±Y direction, which requires that the spaces K1, K2 be provided near the light emitting element 1. This makes the distance D long, which makes the ranging system large. The distance D according to the present comparative example includes a length D1 required for disposing the light emitting device 1 and the light receiving device 2 and a length D2 required for providing the spaces K1, K2.

B of Fig. 17 illustrates the light emitting device 1 according to the present embodiment. The light emitting device 1 according to the present embodiment includes two sets of coils 16 and magnets 17 only in the ±X direction of the holder 15. Therefore, the light emitting device 1 according to the present embodiment can drive the holder 15 only in the ±X direction as indicated by an arrow Ax. In other words, the holder 15 according to the present embodiment is driven along one axis in the ±X direction.

B of Fig. 17 further illustrates the distance D (baseline length) between the center axis of the light emitting device 1 and the center axis of the light receiving device 2, and a space K3 that can be saved as compared with the comparative example. According to the present embodiment, the holder 15 is not driven in the ±Y direction, which eliminates the need of providing the spaces K1, K2 near the light emitting element 1. Therefore, according to the present embodiment, the distance D can be made short, which allows a reduction in size of the ranging system. The distance D according to the present embodiment includes the length D1 required for disposing the light emitting device 1 and the light receiving device 2, but does not include the length D2 required for providing the spaces K1, K2.

According to the present embodiment, it is possible to lower a manufacturing cost of the light emitting device 1 (ranging system) by making the light emitting device 1 (ranging system) smaller in size and reducing the number of components. Moreover, according to the present embodiment, making the baseline length shorter makes it possible to implement the light emitting device 1 (ranging system) suitable for short-distance measurement.

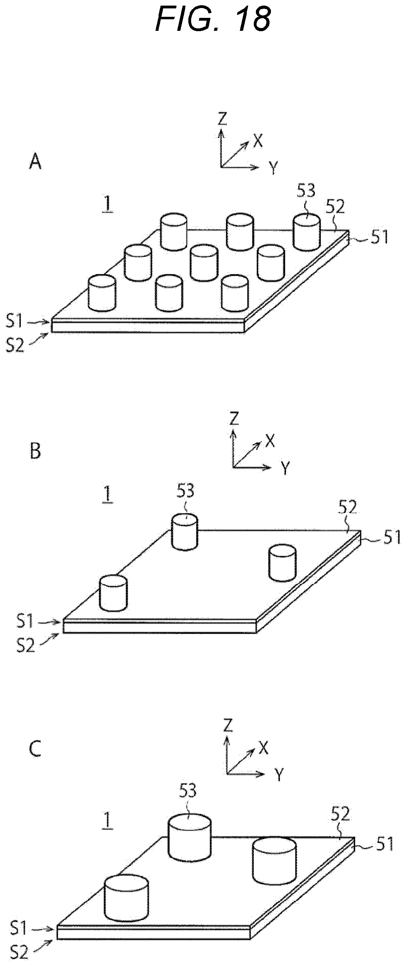

Fig. 18 is another perspective view for describing the details of the light emitting device 1 according to the first embodiment.

A of Fig. 18 illustrates the substrate 51, the laminated film 52, and the light emitting elements 53 of the light emitting device 1 according to the comparative example of the present embodiment. A of Fig. 18 illustrates, for the sake of easy understanding of the description, the light emitting device 1 with the front surface S1 of the substrate 51 facing the +Z direction and the back surface S2 of the substrate 51 facing the -Z direction. The same applies to B and C of Fig. 18 to be described later.

It is assumed that the light emitting device 1 according to the present comparative example include neither the coil 16 nor the magnet 17. Therefore, the light emitting device 1 according to the present comparative example includes the light emitting elements 53 on the front surface S1 of the substrate 51 with high density.

B of Fig. 18 illustrates the substrate 51, the laminated film 52, and the light emitting elements 53 of the light emitting device 1 according to the present embodiment. As described above, the light emitting device 1 according to the present embodiment includes two sets of the coils 16 and the magnets 17 in the ±X direction of the holder 15. Therefore, according to the present embodiment, it is possible to irradiate a large number of ranging points P with the light using a small number of light emitting elements 53. Therefore, the light emitting device 1 illustrated in B of Fig. 18 includes the light emitting elements 53 on the front surface S1 of the substrate 51 with low density.

C of Fig. 18 also illustrates the substrate 51, the laminated film 52, and the light emitting elements 53 of the light emitting device 1 according to the present embodiment. According to the present embodiment, it is possible to arrange the light emitting elements 53 on the front surface S1 of the substrate 51 with low density. Therefore, as illustrated in C of Fig. 18, each light emitting element 53 may be made larger in size than each light emitting element 53 illustrated in A and B of Fig. 18. This allows a large current to flow through each light emitting element 53 and thus allows an increase in distance by which the ranging system can perform measurement. Moreover, the connections between the anode electrodes 54 and the connection pads 56 and the connections between the cathode electrodes 55 and the connection pads 56 can be easily made with solder rather than the bumps 57, so that the use of solder allows a reduction in cost of such connections.

As described above, the light emitting elements 53 according to the present embodiment are arranged at the intersections of the plurality of first straight lines L1 extending in the Y direction and the plurality of second straight lines L2 extending in the direction parallel to neither the X direction nor the Y direction. Moreover, the light emitting elements 53 adjacent to each other in the X direction on the first straight lines L1 are arranged so as not to be adjacent to each other in the X direction. Therefore, according to the present embodiment, the irradiation position of the light can be moved by a suitable method, for example, the irradiation position of the light can be moved to various places by uniaxial drive.

Note that the light emitting device 1 according to the present embodiment is used as the light source of the ranging system, but may be used in other aspects. For example, the light emitting device 1 according to the present embodiment may be used as a light source of optical equipment such as a printer, or may be used as a lighting device. Furthermore, the ranging system according to the present embodiment may be used for any purpose, and, for example, may be used for biometric authentication such as facial recognition or gesture recognition.

Although the embodiment of the present disclosure has been described above, the above-described embodiment may be implemented with various modifications without departing from the gist of the present disclosure. For example, two or more examples of the above-described embodiment may be implemented in combination.

Note that the present disclosure may have the following configurations.

(1) A light emitting device including:
   a plurality of light emitting elements configured to generate light; and
   a moving unit configured to move an irradiation position of the light by driving a predetermined portion related to the light in a first direction, in which
   the light emitting elements are arranged at intersections of a plurality of first straight lines extending in a second direction orthogonal to the first direction and a plurality of second straight lines extending in a third direction parallel to neither the first direction nor the second direction,
   the first straight lines include a straight line A and a straight line B adjacent to the straight line A in the first direction, and
   the light emitting elements on the straight line A and the light emitting elements on the straight line B are arranged so as not to be adjacent to each other in the first direction.
(2) The light emitting device according to (1), in which the predetermined portion includes an optical system through which the light from the light emitting elements passes.
(3) The light emitting device according to (2), in which the optical system includes at least one of a lens or a diffractive optical element through which the light from the light emitting elements passes.
(4) The light emitting device according to (1), in which the moving unit includes a coil, a magnet, a piezoelectric element, or a shape-memory alloy.
(5) The light emitting device according to (1), in which the moving unit is provided only in the first direction of the predetermined portion out of the first direction and the second direction of the predetermined portion.
(6) The light emitting device according to (1), in which the moving unit drives the predetermined portion in the first direction and a direction opposite to the first direction.
(7) The light emitting device according to (1), further including a substrate on which the light emitting elements are provided.
(8) The light emitting device according to (7), in which
   the light emitting elements are provided on a first surface of the substrate, and
   the light from the light emitting elements passes through the substrate from the first surface to a second surface to exit from the second surface of the substrate.
(9) The light emitting device according to (1), in which the light emitting elements are arranged in a triangular lattice.
(10) The light emitting device according to (1), in which in a case where a minimum pitch between the light emitting elements in the second direction is Δ, a minimum pitch between the light emitting elements in the first direction is N * Δ (where N is an integer greater than or equal to 2).
(11) The light emitting device according to (1), in which in a case where a minimum pitch between the light emitting elements in the second direction is Δ, a pitch in the first direction between the light emitting elements adjacent to each other in the first direction is N² * Δ (where N is an integer greater than or equal to 2).
(12) The light emitting device according to (1), in which in a case where a minimum pitch between the light emitting elements in the second direction is Δ, a pitch in the second direction between the light emitting elements adjacent to each other in the second direction is N * Δ (where N is an integer greater than or equal to 2).
(13) The light emitting device according to (1), in which in a case where a minimum pitch between the light emitting elements in the second direction is Δ, a region provided for each of the light emitting elements is square with a side length of N * Δ (where N is an integer greater than or equal to 2).
(14) A ranging system including:
   a light emitting device configured to irradiate a subject with light;
   a light receiving device configured to receive light reflected off the subject; and
   a ranging device configured to measure a distance to the subject on the basis of the light received by the light receiving device, in which
   the light emitting device includes:
      a plurality of light emitting elements configured to generate the light; and
      a moving unit configured to move an irradiation position of the light by driving a predetermined portion related to the light in a first direction,
   the light emitting elements are arranged at intersections of a plurality of first straight lines extending in a second direction orthogonal to the first direction and a plurality of second straight lines extending in a third direction parallel to neither the first direction nor the second direction,
   the first straight lines include a straight line A and a straight line B adjacent to the straight line A in the first direction, and
   the light emitting elements on the straight line A and the light emitting elements on the straight line B are arranged so as not to be adjacent to each other in the first direction.
(15) The ranging system according to (14), in which the light receiving device includes an imaging unit configured to capture an image of the light reflected off the subject.
(16) The ranging system according to (14), in which the light receiving device is provided in the second direction of the light emitting device.
(17) The ranging system according to (14), in which at least a part of the light emitting device and at least a part of the light receiving device are provided on a surface of the same substrate.
(18) The ranging system according to (14), in which in a case where a minimum pitch between the light emitting elements in the second direction is Δ, a pitch in the first direction between the light emitting elements adjacent to each other in the first direction is N² * Δ (where N is an integer greater than or equal to 2).
(19) The ranging system according to (18), in which the moving unit performs an operation of driving the predetermined portion in the first direction N² - 1 times to cause a plurality of ranging points to be sequentially irradiated with the light.
(20) The ranging system according to (18), in which the moving unit performs an operation of driving the predetermined portion in the first direction and an operation of driving the predetermined portion in a direction opposite to the first direction N² - 1 times to cause a plurality of ranging points to be sequentially irradiated with the light.
(21) A light emitting device including:
   a plurality of light emitting elements configured to generate light; and
   a moving unit configured to move an irradiation position of the light by driving a predetermined portion related to the light in a first direction, in which
   in a case where a minimum pitch between the light emitting elements in a second direction orthogonal to the first direction is Δ, a pitch in the first direction between the light emitting elements adjacent to each other in the first direction is N² * Δ (where N is an integer greater than or equal to 2), and a pitch in the second direction between the light emitting elements adjacent to each other in the second direction is N * Δ.

### REFERENCE SIGNS LIST

- 1: Light emitting device
- 2: Light receiving device
- 3: Control device
- 11: Light source drive unit
- 12: Light source
- 13: Collimating lens
- 14: Diffractive optical element
- 15: Holder
- 16: Coil
- 17: Magnet
- 21: Lens unit
- 22: Imaging unit
- 23: Imaging signal processing unit
- 24: Filter
- 31: Ranging unit
- 41: Substrate
- 42: First housing
- 43: Second housing
- 51: Substrate
- 52: Laminated film
- 53: Light emitting element
- 53': Portion where no light emitting element is present
- 54: Anode electrode
- 55: Cathode electrode
- 56: Connection pad
- 57: Bump

## Claims

1. A light emitting device comprising:
a plurality of light emitting elements configured to generate light; and
a moving unit configured to move an irradiation position of the light by driving a predetermined portion related to the light in a first direction, wherein
the light emitting elements are arranged at intersections of a plurality of first straight lines extending in a second direction orthogonal to the first direction and a plurality of second straight lines extending in a third direction parallel to neither the first direction nor the second direction,
the first straight lines include a straight line A and a straight line B adjacent to the straight line A in the first direction, and
the light emitting elements on the straight line A and the light emitting elements on the straight line B are arranged so as not to be adjacent to each other in the first direction.

2. The light emitting device according to claim 1, wherein the predetermined portion includes an optical system through which the light from the light emitting elements passes.

3. The light emitting device according to claim 2, wherein the optical system includes at least one of a lens or a diffractive optical element through which the light from the light emitting elements passes.

4. The light emitting device according to claim 1, wherein the moving unit includes a coil, a magnet, a piezoelectric element, or a shape-memory alloy.

5. The light emitting device according to claim 1, wherein the moving unit is provided only in the first direction of the predetermined portion out of the first direction and the second direction of the predetermined portion.

6. The light emitting device according to claim 1, wherein the moving unit drives the predetermined portion in the first direction and a direction opposite to the first direction.

7. The light emitting device according to claim 1, further comprising a substrate on which the light emitting elements are provided.

8. The light emitting device according to claim 7, wherein
the light emitting elements are provided on a first surface of the substrate, and
the light from the light emitting elements passes through the substrate from the first surface to a second surface to exit from the second surface of the substrate.

9. The light emitting device according to claim 1, wherein the light emitting elements are arranged in a triangular lattice.

10. The light emitting device according to claim 1, wherein in a case where a minimum pitch between the light emitting elements in the second direction is Δ, a minimum pitch between the light emitting elements in the first direction is N * Δ (where N is an integer greater than or equal to 2).

11. The light emitting device according to claim 1, wherein in a case where a minimum pitch between the light emitting elements in the second direction is Δ, a pitch in the first direction between the light emitting elements adjacent to each other in the first direction is N² * Δ (where N is an integer greater than or equal to 2).

12. The light emitting device according to claim 1, wherein in a case where a minimum pitch between the light emitting elements in the second direction is Δ, a pitch in the second direction between the light emitting elements adjacent to each other in the second direction is N * Δ (where N is an integer greater than or equal to 2).

13. The light emitting device according to claim 1, wherein in a case where a minimum pitch between the light emitting elements in the second direction is Δ, a region provided for each of the light emitting elements is square with a side length of N * Δ (where N is an integer greater than or equal to 2).

14. A ranging system comprising:
a light emitting device configured to irradiate a subject with light;
a light receiving device configured to receive light reflected off the subject; and
a ranging device configured to measure a distance to the subject on a basis of the light received by the light receiving device, wherein
the light emitting device includes:
a plurality of light emitting elements configured to generate the light; and
a moving unit configured to move an irradiation position of the light by driving a predetermined portion related to the light in a first direction,
the light emitting elements are arranged at intersections of a plurality of first straight lines extending in a second direction orthogonal to the first direction and a plurality of second straight lines extending in a third direction parallel to neither the first direction nor the second direction,
the first straight lines include a straight line A and a straight line B adjacent to the straight line A in the first direction, and
the light emitting elements on the straight line A and the light emitting elements on the straight line B are arranged so as not to be adjacent to each other in the first direction.

15. The ranging system according to claim 14, wherein the light receiving device includes an imaging unit configured to capture an image of the light reflected off the subject.

16. The ranging system according to claim 14, wherein the light receiving device is provided in the second direction of the light emitting device.

17. The ranging system according to claim 14, wherein at least a part of the light emitting device and at least a part of the light receiving device are provided on a surface of a same substrate.

18. The ranging system according to claim 14, wherein in a case where a minimum pitch between the light emitting elements in the second direction is Δ, a pitch in the first direction between the light emitting elements adjacent to each other in the first direction is N² * Δ (where N is an integer greater than or equal to 2).

19. The ranging system according to claim 18, wherein the moving unit performs an operation of driving the predetermined portion in the first direction N² - 1 times to cause a plurality of ranging points to be sequentially irradiated with the light.

20. The ranging system according to claim 18, wherein the moving unit performs an operation of driving the predetermined portion in the first direction and an operation of driving the predetermined portion in a direction opposite to the first direction N² - 1 times to cause a plurality of ranging points to be sequentially irradiated with the light.

21. A light emitting device comprising:
a plurality of light emitting elements configured to generate light; and
a moving unit configured to move an irradiation position of the light by driving a predetermined portion related to the light in a first direction, wherein
in a case where a minimum pitch between the light emitting elements in a second direction orthogonal to the first direction is Δ, a pitch in the first direction between the light emitting elements adjacent to each other in the first direction is N² * Δ (where N is an integer greater than or equal to 2), and a pitch in the second direction between the light emitting elements adjacent to each other in the second direction is N * Δ.
